# EUROPEAN PATENT APPLICATION

(11) **EP 1 113 273 A2**
(43) Date of publication of application: **04.07.2001**
(21) Application number: 00128053.6
(22) Date of filing: 21.12.2000
(51) Int. Cl.: G01R 1/04

(54) **System for testing bare IC chips and a socket for such chips**

(30) Priority: 28.12.1999 JP 37297999
(71) Applicant: MOLEX INCORPORATED, Lisle Illinois 60532 (US)
(72) Inventor: Maeda, Ryu, Tokyo, 183-0011 (JP); Doi, Manabu, Dazaifu-shi, Fukoka-ken (JP)
(74) Representative: Blumbach, Kramer & Partner GbR

(57) **Abstract**

A system is provided for testing a bare IC chip having an array of electrode pads. A burn-in socket includes a dielectric housing having a receptacle. A plurality of terminals on the housing include contact portions exposed in the receptacle and terminating portions extending exteriorly of the housing. An adapter socket is configured for positioning in the receptacle in the burn-in socket and includes an opening for removably receiving the bare IC chip. A plurality of conductors have contact portions exposed in the opening for engaging the electrode pads of the bare IC chip. Connection portions of the conductors engage the contact portions of the terminals of the burn-in socket. The conductors are formed on a laminated film which is part of the adapter socket.

## Description

### Field of the Invention

This invention generally relates to the art of IC sockets and, particularly, to a system for testing a bare IC chip as well as an IC socket, per se, for such bare chips.

### Background of the Invention

Semiconductor devices or IC chips are sealed and packaged in epoxy resin. An IC socket is used for performing burn-in tests on such IC packages before they are marketed. In essence, an IC package is tested for a given number of hours at given, sometimes elevated temperatures to ensure that the IC package will not fail during normal operation. Such an IC socket typically includes a dielectric socket body or housing which mounts a plurality of terminals in respective terminal-receiving passages in the body. Contact ends of the terminals engage an array of electrode pads on the IC package, and the opposite ends of the terminals have tails which engage circuit traces on a printed circuit board.

With the ever-increasing miniaturization of computers or other electronic devices which use such semiconductor devices or IC chip packages, the chips are being used more frequently without being packaged in an epoxy resin. The unpackaged semiconductor devices typically are called "bare" IC chips. IC sockets for testing bare IC chips have been proposed in Japanese Patent Application Laid-Open Nos. 7-326692 and 8-22875 and Japanese Patent No. 2728858. These IC sockets, however, have replaceable supports in the bottoms thereof. In effecting burn-in tests on varying bare IC chips, the supports must be replaced by other supports for this purpose. Such systems increase the manufacturing costs of the IC sockets and require considerable operator time during use.

The present invention is directed to solving these problems by a novel system which employs an adapter socket for receiving a bare IC chip, with the adapter socket, in turn, being positionable in the IC socket used for burn-in tests. The invention also uses a novel conductor film in the adapter socket for interconnecting the electrodes of the bare IC chip with the terminals of the bum-in socket.

### Summary of the Invention

An object, therefore, of the invention is to provide a new and improved system for testing a bare IC chip.

Another object of the invention is to provide a new and improved socket for a bare IC chip having an array of electrode pads.

In the exemplary embodiment of the invention, the system includes a burn-in socket having a dielectric housing with a receptacle. A plurality of terminals are mounted on the housing, with contact portions of the terminals exposed in the receptacle. Terminating portions of the terminals extend exteriorly of the housing. An adapter socket is configured for positioning in the receptacle of the burn-in socket and includes an opening for removably receiving the bare IC chip. A plurality of conductors on the adapter socket have contact portions exposed in the opening for engaging the electrode pads of the bare IC chip. The conductors have connection portions for engaging the contact portions of the terminals of the burn-in socket. Preferably, the contact portions of the conductors include raised bumps for engaging the electrode pads of the bare IC chip.

According to one aspect of the invention, the adapter socket includes a base having the chip-receiving opening therein, and a cover for the base to hold the bare IC chip in the opening. The cover includes a spring-loaded plunger for engaging the bare IC chip and biasing the chip into the opening in the base. Complementary interengaging pivot means are provided between the base and the cover to mount the cover on the base for pivotal movement between open and closed positions. Complementary interengaging latch means are provided between the base and the cover to hold the cover in its closed position.

According to another aspect of the invention, a laminated film is mounted on the adapter socket, such as on the base of the socket, and the conductors are elements of the laminated film. Specifically, the conductors are disposed on a dielectric layer, with the connecting portions of the conductors projecting beyond at least one edge of the dielectric layer. A conductive ground foil is disposed on a side of the dielectric layer opposite the conductors. An electrically resistive coating is deposited on the conductors. A frame is mounted on the base of the adapter socket over the laminated film to define the opening which receives a bare IC chip.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a top plan view of a burn-in socket of a type used in the system of the invention;
FIGURE 2 is a vertical section taken generally along line 2-2 of Figure 1;
FIGURE 3 is a section through an adapter socket for a bare IC chip according to the concepts of the invention, with the cover of the socket in its open position;
FIGURE 4 is a view similar to that of Figure 3, with the cover in its closed position;
FIGURE 5 is a top plan view of the base of the adapter socket;
FIGURE 6 is a vertical section taken generally along line 6-6 of Figure 5;
FIGURE 7 is an end elevational view looking toward the left-hand ends of Figures and 6;
FIGURE 8 is an enlarged, fragmented section through the laminated film used with the adapter socket, with the bare IC chip shown on top of the film;
FIGURE 9 is a top plan view of the laminated film, with the array of electrode pads omitted;
FIGURE 10 is a bottom plan view of the laminated film;
FIGURE 11 is a fragmented, enlarged view of an end of one of the conductors of the laminated film;
FIGURE 12 is an enlarged vertical section showing the end area of the one conductor; and
FIGURE 13 is an enlarged, fragmented section through an area of the frame to show the configuration of the opening which receives the bare IC chip.

### Detailed Description of the Preferred Embodiment

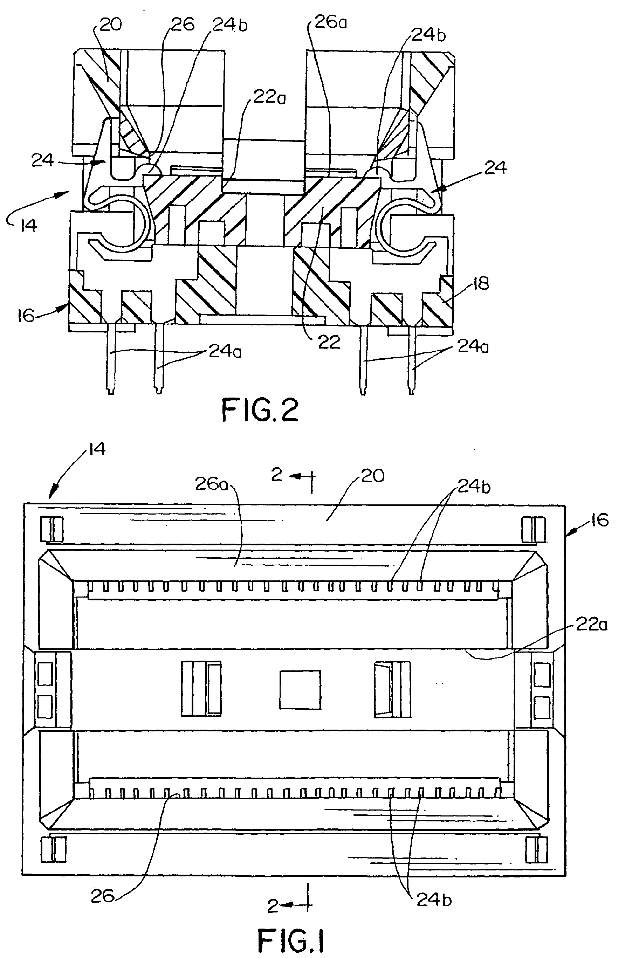

Referring to the drawings in greater detail, and first to Figures 1 and 2, a burn-in socket, generally designated 14, includes a three-part dielectric housing, generally designated 16, which includes a lower part 18, an upper part 20 and an insert 22. A plurality of terminals, generally designated 24, are mounted on the housing, particularly lower part 18. The terminals have terminating portions or tails 24a projecting below the lower housing part for insertion into appropriate holes in a printed circuit board (not shown). Upper housing part 20 defines a receptacle 26. Insert 22 defines a bottom wall 26a of the receptacle. Terminals 24 have contact portions 24b exposed within receptacle 26 along opposite longitudinal sides thereof as best seen in Figure 1. Insert 22 has a longitudinal trough 22a in the top surface thereof.

Generally, burn-in socket 14 is of typical construction and is sized for receiving a typical semiconductor or IC chip package. In essence, upper housing part 20 is displaced downwardly toward lower housing part 18 which is effective to cause contact portions 24b of terminals 24 to raise slighting and engage the leads of the IC chip package.

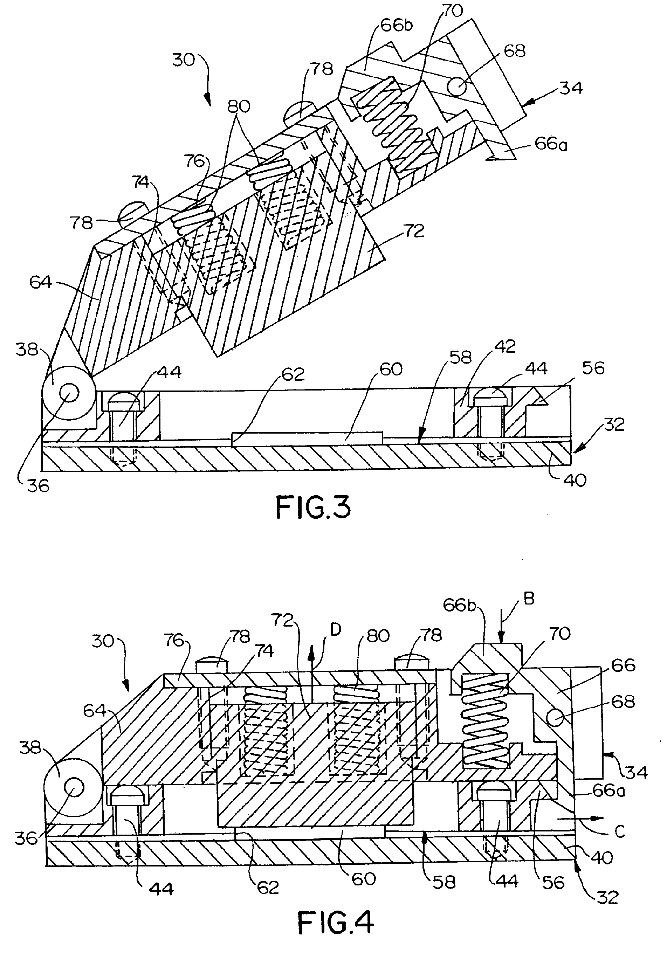

The system of the invention contemplates the use of an adapter socket, generally designated 30 and shown in Figures 3 and 4. The adapter socket includes a base, generally designated 32, and a cover, generally designated 34. A pivot pin 36 on the base extends through a pivot journal 38 on the cover to mount the cover on the base for pivotal movement in the direction of arrow "A" (Fig. 3) between an open position shown in Figure 3 and a closed position shown in Figure 4.

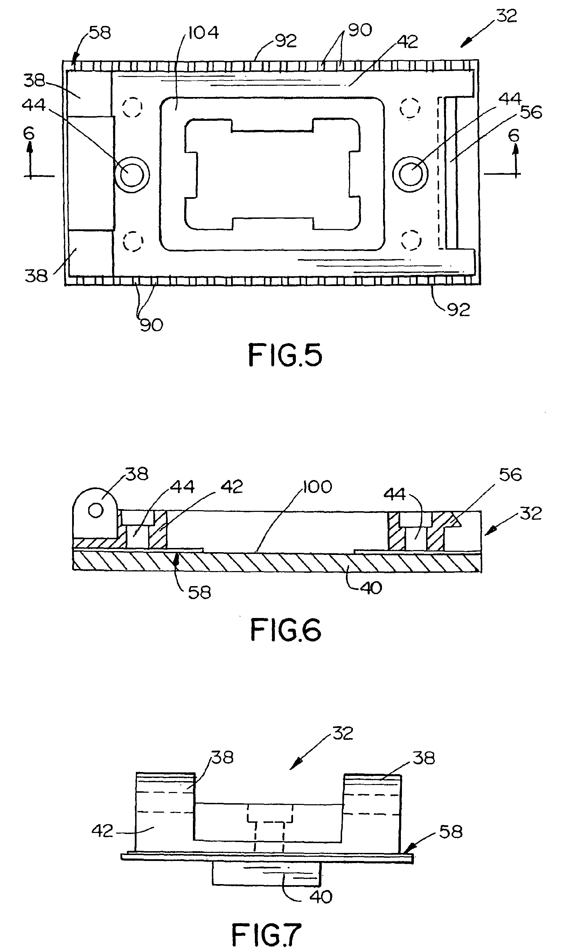

More particularly, referring to Figures 5-7 in conjunction with Figures 3 and 4, base 32 of adapter socket 30 includes a lower support bar 40 and an upper retainer 42. The support bar may be of conductive metal material and the retainer may be of dielectric material such as plastic. The upper retainer is secured to the lower support bar by appropriate fastening means such as bolts 44 extending through the retainer and threaded into the support bar. A chamfered latch hook 56 projects outwardly from upper retainer 42. As will be understood in greater detail hereinafter, base 32 mounts a laminated film, shown generally or schematically at 58 in Figures 3 and 4. A bare IC chip 60 is mounted in an opening 62 of the laminated film.

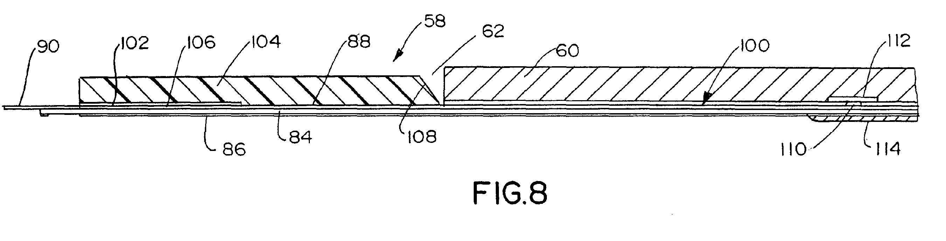

Cover 34 of adapter socket 30 is shown in Figures 3 and 4 to include a dielectric frame 64 such as of plastic material having pivot journal 38 molded integrally therewith. A latch arm 66 is pivotally mounted between its opposite ends to frame 64 by a pivot pin 68. One end 66a of the latch arm defines a chamfered latch hook for interengagement with chamfered latch hook 56 of base 32 to hold cover 34 in its closed position on the base as shown in Figure 8. In order to unlatch the cover, the cover is spring-loaded by a coil spring 70 sandwiched between frame 64 and an opposite end 66b of latch arm 66. End 66b of latch arm 66 is depressed downwardly in the direction of arrow "B" (Fig. 8) against the biasing of spring 70. This causes latch hook 66a at the opposite end of the latch arm to pivot outwardly in the direction of arrow "C", out of engagement with latch hook 56 of the base, to allow the cover to be opened.

Still referring to Figures 3 and 4, cover 34 of adapter socket 30 includes a spring-loaded plunger 72 which biases bare IC chip 60 into opening 62. Specifically, plunger 72 is reciprocally mounted within a passage 74 in frame 64. The passage is closed by a lid 76 secured to the frame by fasteners 78. A pair of coil springs 80 are sandwiched between plunger 72 and lid 76 to bias the plunger downwardly toward the base. When cover 34 is closed onto the base as shown in Figure 4, plunger 72 moves upwardly in the direction of arrow "D" (Fig. 4) against the biasing of springs 80.

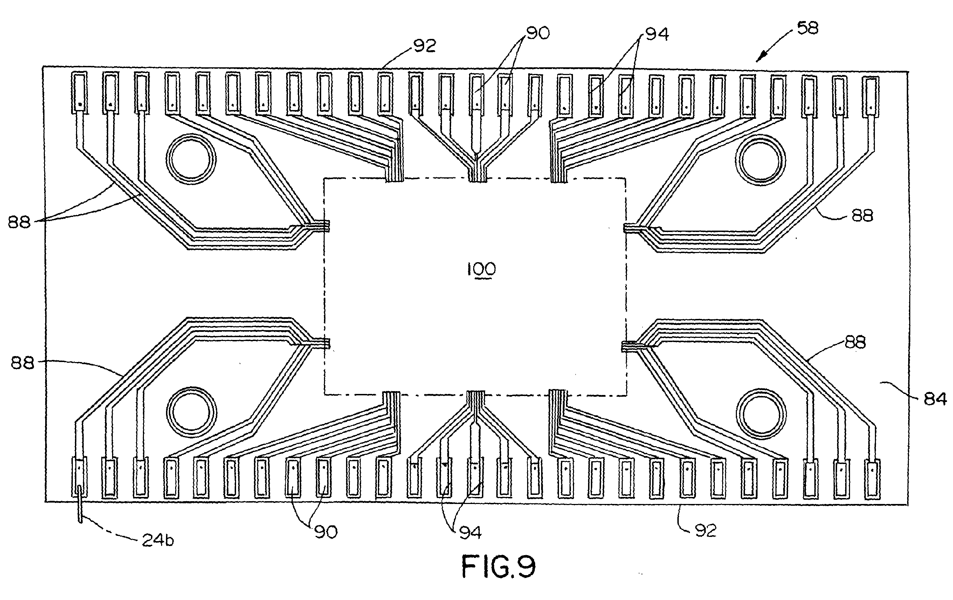

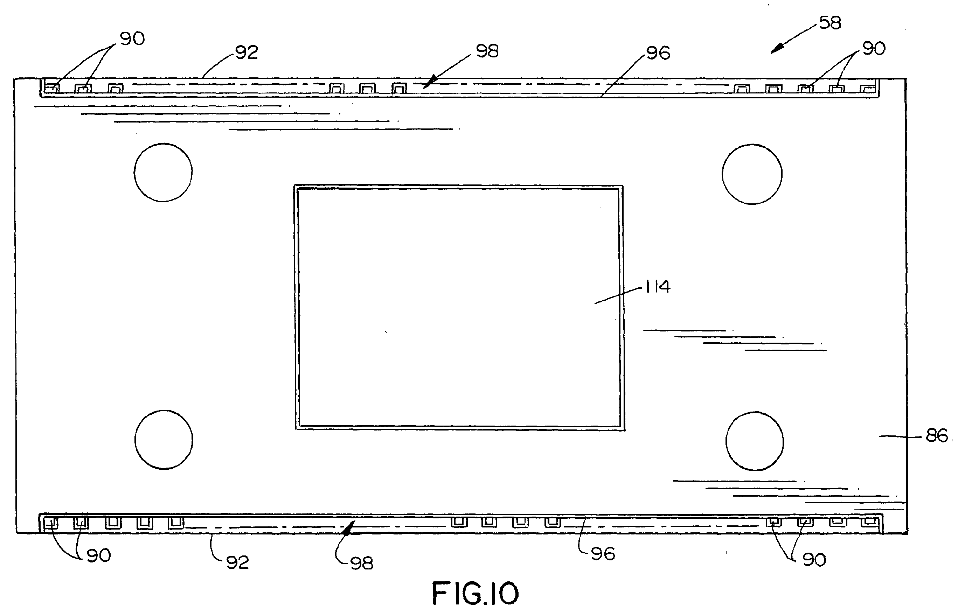

The construction of laminated film 58 which, in essence, is a component of base 32 of adapter socket 30, is shown in Figures 8-12. Referring first to Figures 8-10, laminated film 62 includes a dielectric or polyamide layer 84 having a grounding foil 86 adhered to the bottom side thereof. The grounding foil functions as a grounding layer and may be of such conductive material as copper or other metal. A plurality of conductors 88 are deposited on the dielectric layer, and the conductors terminate in connecting portions or pads 90 spaced along opposite edges 92 of the laminated film. Dielectric layer 84 is cut-out at 94 in Figure 9, and grounding foil 86 is cut-out at 96 in Figure 10 so that connecting pads 90 are exposed in areas 98 (Fig. 10) at the bottom of the film along edges 92 thereof for engaging contact portions 24b (Fig. 1) of terminals 24 (Fig. 2) of burn-in socket 14. As will be described below, conductors 88 terminate in contact portions somewhere within an area 100 (Fig. 9) where bare IC chip 60 will be located.

Conductors 88 of laminated film 58 have an electrically resistive coating 102 (Fig. 8) on the top thereof. Opening 62 for receiving bare IC chip 60 is formed by a frame 104 which is secured on the film by an adhesive 106. The frame is fabricated by etching opening 62 in a thin sheet of stainless steel material, or by electroforming or machining. Alternatively, frame 104 may be molded of insulating resin material or ceramics. The frame has a chamfered or angled inner edge 108 about opening 62 to facilitate guiding bare IC chip 60 into the opening.

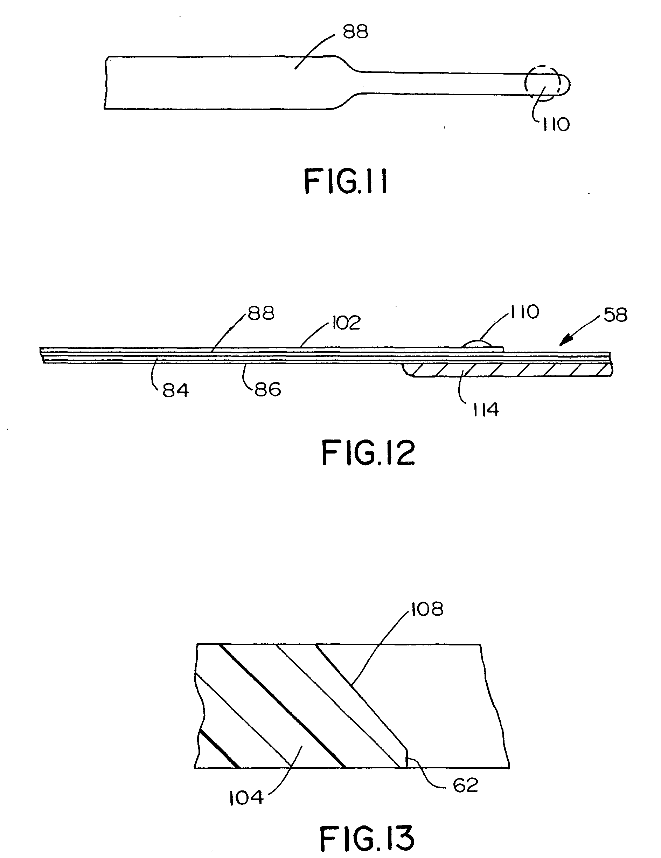

Referring to Figures 11 and 12 in conjunction with Figures 8-10, each conductor 88 extends into bare IC chip-receiving area 100 (Fig. 9) and terminates in a contact portion 110 for engaging a respective electrode pad 112 (Fig. 8) on the underside of bare IC chip 60. As best seen in Figures 8 and 12, contact portions 110 are formed by raised bumps to establish good positive engagement with the electrode pads of the bare IC chip. Although not specifically shown in the drawings, the electrode pads on the underside of the bare IC chip will be in a given array according to the chip's application or use. Correspondingly, conductors 88 will extend into area 100 (Fig. 9) and terminate in contact portions or raised bumps 110 which are located or arranged in a pattern corresponding to the array of the electrode pads on the bare IC chip. In order to further ensure a good positive engagement between contact portions 110 and the electrode pads of the bare IC chip, a resilient or elastomeric layer 114 (Figs. 8 and 12) is adhered to the underside of grounding foil 30 of the laminated film.

The entire laminated film 58 is mounted on base 32 (Figs. 7 and 8) of adapter socket 30 between lower support bar 40 and upper retainer 42. The upper retainer seats over the top of frame 104 as best seen in Figure 9. In essence, the laminated film is clamped between the lower support bar and the upper retainer by fastening bolts 44. Figure 7 shows that support bar 40 is narrower than the entire base, and the support bar is dimensioned to fit into trough 22a (Figs. 1 and 2) in insert 22 of burn-in socket 14.

In use, it should be understood that relatively large burn-in sockets, such as socket 14, and their numerous elaborate terminals are relatively expensive to manufacture. A burn-in socket such as socket 14 can be permanently mounted on a testing printed circuit board. Thereafter, adapter socket 30 can be used to test various bare IC chips. The main mechanical components, including base 32 and its elements, as well as cover 34 and its elements, do not have to be changed for different bare IC chips. The only component that needs to be changed is laminated film 58. In fact, looking at Figure 9, area 100 is the only portion of the entire laminated film which needs to be varied for different bare IC chips having different arrays of electrode pads. In summation, it can be understood that changes in the entire system of the invention, including burn-in socket 14 , adapter socket 30 and laminated film 58 can be changed or modified with very minimal effort and expense to accommodate bare IC chips having a wide variety of electrode arrays.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. A system for testing a bare IC chip having an array of electrode pads, comprising:
a burn-in socket including a dielectric housing having a receptacle, and a plurality of terminals mounted on the housing with contact portions exposed in the receptacle and terminating portions extending exteriorly of the housing; and
an adapter socket configured for positioning in the receptacle of the burn-in socket and including an opening for removably receiving the bare IC chip, and a plurality of conductors having contact portions exposed in the opening for engaging the electrode pads of the bare IC chip and connection portions for engaging the contact portions of the terminals of the burn-in socket.

2. The system of claim 1 wherein said adapter socket includes a base having said opening therein and a cover for the base to hold the bare IC chip in the opening the base.

3. The system of claim 2 wherein said cover includes a spring-loaded plunger for engaging the bare IC chip and biasing the chip into the opening in the base.

4. The system of claim 2, including complementary interengaging latch means between the base and the cover to hold the cover in a closed position.

5. The system of claim 2, including complementary interengaging pivot means between the base and the cover to mount the cover on the base for pivotal movement between open and closed positions.

6. The system of claim 1 wherein the contact portions of said conductors comprise raised bumps for engaging the electrode pads of the bare IC chip.

7. The system of claim 1, including a laminated film on the adapter socket, said conductors being elements of the laminated film.

8. The system of claim 7 wherein said laminated film includes a dielectric layer on which the conductors are disposed.

9. The system of claim 8 wherein said connecting portions of the conductors project beyond at least one edge of the dielectric layer.

10. The system of claim 8 wherein said laminated film includes a conductive ground foil on a side of the dielectric layer opposite the conductors.

11. The system of claim 8, including an electrically resistive coating on the conductors.

12. The system of claim 8 wherein said adapter socket includes a frame on the laminated film defining said opening.

13. A system for testing a bare IC chip having an array of electrode pads, comprising:
a burn-in socket including a dielectric housing having a receptacle, and a plurality of terminals mounted on the housing with contact portions exposed in the receptacle and terminating portions extending exteriorly of the housing; and
an adapter socket configured for positioning in the receptacle of the burn-in socket and including
a base having an opening for removably receiving the bare IC chip,
a cover for the base to hold the bare IC chip in the opening, and
a laminated film on the base and including a plurality of conductors having contact portions exposed in the opening for engaging the electrode pads of the bare IC chip and connection portions for engaging the contact portions of the terminals of the burn-in socket.

14. The system of claim 13 wherein said laminated film includes a dielectric layer on which the conductors are disposed.

15. The system of claim 14 wherein said connecting portions of the conductors project beyond at least one edge of the dielectric layer.

16. The system of claim 14 wherein said laminated film includes a conductive ground foil on a side of the dielectric layer opposite the conductors.

17. The system of claim 14, including an electrically resistive coating on the conductors.

18. The system of claim 13 wherein said cover includes a spring-loaded plunger for engaging the bare IC chip and biasing the chip into said opening.

19. The system of claim 13, including complementary interengaging latch means between the base and the cover to hold the cover in a closed position.

20. The system of claim 13, including complementary interengaging pivot means between the base and the cover to mount the cover on the base for pivotal movement between open and closed positions.

21. The system of claim 13 wherein the contact portions of said conductors comprise raised bumps for engaging the electrode pads of the bare IC chip.

22. A socket for a bare IC chip having an array of electrode pads, comprising:
a base having an opening for removably receiving the bare IC chip;
a laminated film on the base and including a plurality of conductors having contact portions in the form of raised bumps exposed in the opening for engaging the electrode pads of the base IC chip and connection portions at a periphery of the base for engagement with terminals of an electronic device; and
a cover on the base to hold the bare IC chip in the opening in the base.

23. The socket of claim 22 wherein said cover includes a spring-loaded plunger for engaging the bare IC chip and biasing the chip into the opening in the base.

24. The socket of claim 22, including complementary interengaging latch means between the base and the cover to hold the cover in a closed position.

25. The socket of claim 22, including complementary interengaging pivot means between the base and the cover to mount the cover on the base for pivotal movement between open and closed positions.

26. The socket of claim 22 wherein said laminated film includes a dielectric layer on which the conductors are disposed.

27. The socket of claim 26 wherein said connecting portions of the conductors project beyond at least one edge of the dielectric layer.

28. The socket of claim 26 wherein said laminated film includes a conductive ground foil on a side of the dielectric layer opposite the conductors.

29. The socket of claim 22, including an electrically resistive coating on the conductors.

30. The socket of claim 22 wherein said laminated film on the base includes a frame defining said opening.
